# EUROPEAN PATENT APPLICATION

(11) **EP 4 614 804 A1**
(43) Date of publication of application: **10.09.2025**
(21) Application number: 24162086.3
(22) Date of filing: 07.03.2024
(51) Int. Cl.: H02P 31/00

(54) **METHOD OF SYNCHRONIZATION OF SENSORS, COMPUTER PROGRAM PRODUCT AND COMPUTER READABLE STORAGE MEDIUM**

(71) Applicant: ABB SCHWEIZ AG, 5400 Baden (CH)
(72) Inventor: Suszalski, Dominik, 30-404 Kraków (PL); Zygmunt, Tomasz, 33-370 Powroznik (PL); Nowakowski, Krzysztof, 31-952 Kraków (PL); Polednia, Filip, 43-300 Bielsko-Bia a (PL)
(74) Representative: AOMB Polska Sp. z.o.o.

(57) **Abstract**

The present invention relates to a method of synchronization of sensors, attached to an electrical motor, which obtained data used during phase analysis. The present invention also relates to a computer program product and a computer-readable storage medium.

A method of synchronization of sensors, each comprising an internal clock, an accelerometer, a magnetic field sensor and a wireless communication means, for monitoring an electrical motor comprising steps of: a. receiving data related to an acceleration and a magnetic field from the sensors, b. calculating, on a basis of a magnetic field and a position of the sensors, a desynchronization time being a difference between the internal clocks of the sensors, c. shifting, by the desynchronization time, the data related to the acceleration from one of the sensors, d. analyzing of the acceleration data to obtain data related to a vibration phase shift.

## Description

The present invention relates to a method of synchronization of sensors, attached to an electrical motor, which obtained data used during phase analysis. The present invention also relates to a computer program product and a computer-readable storage medium.

In a methods from the prior art a time synchronization of sensors mounted on different part of a motor was accomplished by connecting the sensors to the central unit with cables. That is not cost efficient and prone to failure. The synchronization is also possible to be obtained via external radio signal that synchronizes all the devices in nearby area. That requires both additional radio sensor to be included and the central unit generating the strong enough synchronization signal.

The invention proposes to use the motor own magnetic field to synchronize devices mounted on different parts of an induction motor. It takes advantage of already used magnetometers avoiding need for cables or additional radio sensor and radio emitter unit. It is therefore simpler, less prone to failure and cheaper setup.

A first aspect of the present invention is a method of synchronization of sensors. Each sensor comprising an internal clock, an accelerometer, a magnetic field sensor and a wireless communication means, for monitoring an electrical motor. The method comprising steps of:
a. receiving data related to an acceleration and a magnetic field from the sensors,
b. calculating, on a basis of a magnetic field and a position of the sensors, a desynchronization time being a difference between the internal clocks of the sensors,
c. shifting, by the desynchronization time, the data related to the acceleration from one of the sensors,
d. analyzing of the acceleration data to obtain data related to a vibration phase shift.

Preferably a step e is performed after the step d, namely when analyzing of the acceleration data indicates that there is a malfunction of the electrical motor, an alarm is set.

Preferably the position of the sensor is predefined, preferably the position is provided with a precision of +/-5 degrees.

Preferably the acceleration data are used to calculate the position of the sensors.

Preferably a step f is performed, namely synchronization of the internal clocks of the sensors is performed wirelessly, preferably with a Bluetooth protocol.

Preferably the step f is performed when the desynchronization time is greater than 100ms, preferably it is greater than 8ms.

Preferably before step a, a step g is performed during which one of the sensors emits a synchronization signal which cause other sensors to start acquisition of the data related to the acceleration and the magnetic field of the motor.

A second aspect of the present invention is a computer program product comprising instructions which, when the program is executed by a computer, cause the computer to carry out the method as described hereinbefore.

A third aspect of the present invention is a computer-readable storage medium comprising instructions which, when executed by a computer, cause the computer to carry out the method as described hereinbefore.

A goal of the invention is to provide a method of a synchronization of the sensors without additional equipment and a use of the radio communication such that the a system performing the method will be cheap to manufacture and during an exploitation.

The present invention is presented in figures, which:
Fig. 1 shows a schematic exemplary position of the sensors on the motor,
Fig. 2 shows data obtained from the sensors on the motor as shown in fig. 1.

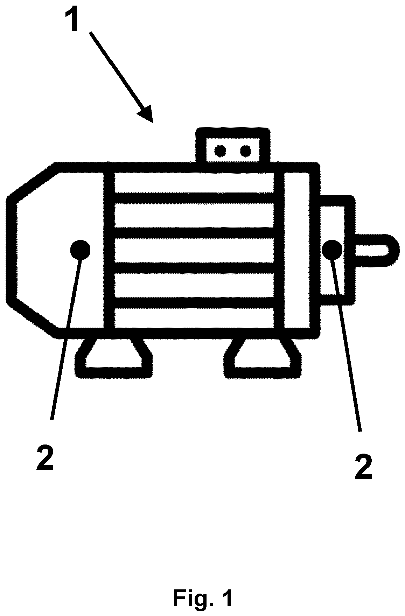

The general concept of the invention is shown in fig. 1, where there are two sensors 2 attached to the motor 1. Those sensors 2 are used to measure acceleration, that is a vibration of the motor, so that a phase analysis may be performed.

In monitoring of the induction motor 1, knowledge of phase difference between motor bearings is of great importance, as it allows one to identify some types of faults like misalignment or unbalance with high certainty. Nowadays, many various cheap sensors 2 are available on the market that can measure both acceleration and magnetic field at their position. As a prior art those sensors 2 are using quartz clocks that desynchronize over time, e.g. one or two weeks, making it impossible to retrieve the vibration phase difference between them. The solution proposes a way to synchronize sensors 2 without a need of cable connection between the sensors 2. The idea is based on presence of rotating magnetic field in the vicinity of an induction motor 1. This field rotates with the same frequence and phase all around the motor 1 making it a great synchronization signal.

A method of synchronization of sensors 2 is thus proposed. The method comprising steps of:
a. receiving data related to an acceleration and a magnetic field from the sensors 2,
b. calculating, on a basis of a magnetic field and a position of the sensors 2, a desynchronization time dT being a difference between the internal clocks of the sensors 2,
c. shifting, by the desynchronization time dT, the data related to the acceleration from one of the sensors,
d. analyzing of the acceleration data to obtain data related to a vibration phase shift.
It should be noted that in the fig. 1 both sensors 2 are in the same angular position - that is both sensors 2 will measure a peak value of magnetic field at the same time. It should be however noted that the sensors 2 may be in different angular positions - for example 90 or 180 degrees from each other and thus measuring the same peak in a different time. Other values are also possible. In this method it is important to know where those sensors 2 are - they respective position may be used to further determine the desynchronization time dT since peak values of the magnetic field will occur in a different time since both sensors are shifted, by some known angle, from each other.

It should also be mentioned that some steps or all steps may be performed locally, in a cloud or other remote computation unit or a server.

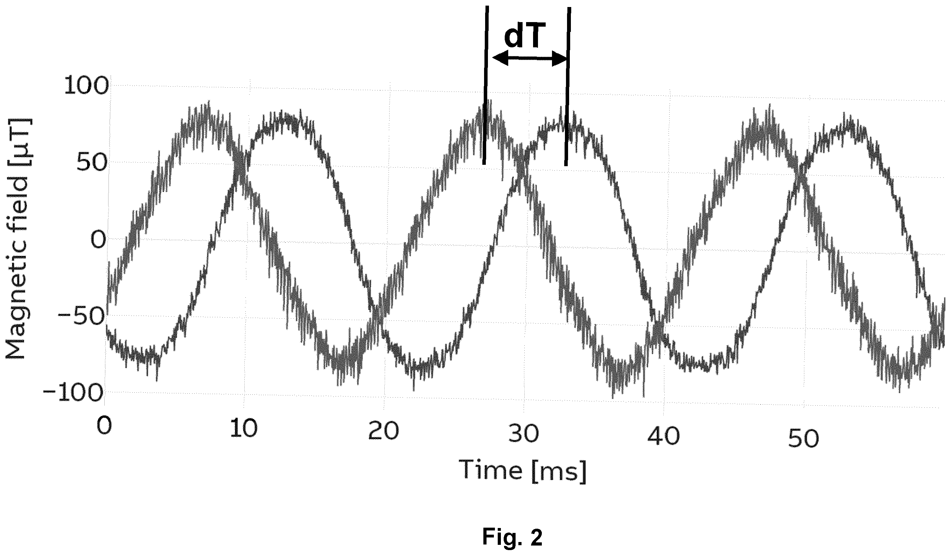

An exemplary data set is presented in fig. 2. In such example both sensors should measure a magnetic peak value in the same time, which is not true according to data obtained. The difference between both data sets may be used to calculate the desynchronization time dT being a difference between a time of the magnetic peak value measured by both sensors 2.

Experimental data shown that such method is possible to use. During an experiment an expected signal RMS was approx. 140 µT where a noise RMS was 0.3 µT. Such values allows to used the magnetic field of the motor 1 to synchronize sensors 2.
In one embodiment a step e is performed after the step d, namely when analyzing of the acceleration data indicates that there is a malfunction of the electrical motor 1, an alarm is set.

In another embodiment the position of the sensor 2 is predefined, preferably the position is provided with a precision of approx. +/-5 degrees. Such accuracy may be obtained by a technician without using any equipment. The acceleration data are used to calculate a an exact position of the sensors 2 - a gravity may be used to provide a more precise angle between the sensors 2. It should be mentioned that sensors 2 are usually placed close to the bearings of the motor 1 such that each senor 2 is near a different bearing.

In yet another embodiment the acceleration data are used to calculate the position of the sensors 2 with minimal prior information regarding positions of the sensors 2. The angle between the sensors 2 is calculated on a basis of the gravity only. It should be however noted that both sensors 2 must be in the same position relative to the motor 1 shaft, that is, for example, that both bottom sides of the sensors 2 points toward the shaft. In such a case it is possible to determine which one of the sensors 2 measure the peak magnetic value first. Such approach is possible when the mounting surface is cylindrical. Alternative approach is to trigger the measurement by magnetic field slope. That would be sensitive though to the offset of magnetization if magnetic DC is not removed.

In another embodiment a step f is performed, namely synchronization of the internal clocks of the sensors 2 is performed wirelessly, preferably with a Bluetooth protocol. It is done so that the desynchronization time dT is within a limits which assure that obtained data may be used. For example the desynchronization time dT should be lower than 100ms, even more preferably lower than 8ms. For obvious reasons a clock synchronization via a wireless communication channel needs to be better that half of a period of a rotation of a motor magnetic field. That is possible with a standard wireless communication. It is expected that such a wireless synchronization will be needed once every 2-3 years at most, usually even every few months.

In the case were the internal clocks of the sensors 2 are desynchronizing in much faster rate such that constant resynchronization is not practical another approach is proposed. In such a case, before the step a, a step g is performed during which one of the sensors 2 emits a synchronization signal which cause other sensors 2 to start acquisition of the data related to the acceleration and the magnetic field of the motor 1. It should be noted that such synchronization signal may also be used with better clocks as an additional measure to provide that the data related to the acceleration and the magnetic field of the motor 1 are collected in a time which allows to used said data in further analysis.

A computer program product comprising instructions which, when the program is executed by a computer, cause the computer to carry out the method is an another aspect of the invention. A computer-readable storage medium comprising instructions which, when executed by a computer, cause the computer to carry out the method is a yet another aspect of the invention.

## Claims

1. A method of synchronization of sensors (2), each comprising an internal clock, an accelerometer, a magnetic field sensor and a wireless communication means, for monitoring an electrical motor (1) comprising steps of:
a. receiving data related to an acceleration and a magnetic field from the sensors (2),
b. calculating, on a basis of a magnetic field and a position of the sensors (2), a desynchronization time (dT) being a difference between the internal clocks of the sensors (2),
c. shifting, by the desynchronization time (dT), the data related to the acceleration from one of the sensors (2),
d. analyzing of the acceleration data to obtain data related to a vibration phase shift.

2. The method according to claim 1, wherein a step e is performed after the step d, namely when analyzing of the acceleration data indicates that there is a malfunction of the electrical motor (1), an alarm is set.

3. The method according to claim 1 or 2, wherein the position of the sensor (2) is predefined, preferably the position is provided with a precision of +/-5 degrees.

4. The method according to anyone of the previous claims, wherein the acceleration data are used to calculate the position of the sensors (2).

5. The method according to anyone of the previous claims, wherein a step f is performed, namely synchronization of the internal clocks of the sensors (2) is performed wirelessly, preferably with a Bluetooth protocol.

6. The method according to claim 6, wherein the step f is performed when the desynchronization time (dT) is greater than 100ms, preferably it is greater than 8ms.

7. The method according to anyone of the previous claims, wherein, before step a, a step g is performed during which one of the sensors (2) emits a synchronization signal which cause other sensors (2) to start acquisition of the data related to the acceleration and the magnetic field of the motor (1).

8. A computer program product comprising instructions which, when the program is executed by a computer, cause the computer to carry out the method of anyone of claims 1-7.

9. A computer-readable storage medium comprising instructions which, when executed by a computer, cause the computer to carry out the method of anyone of claims 1-7.
